# EUROPEAN PATENT APPLICATION

(11) **EP 4 611 029 A1**
(43) Date of publication of application: **03.09.2025**
(21) Application number: 24160702.7
(22) Date of filing: 29.02.2024
(51) Int. Cl.: H01L 21/673, H01L 21/677

(54) **CONTAINER FOR STORING AND/OR TRANSPORTING A SEMICONDUCTOR FABRICATION ARTICLE**

(71) Applicant: Brooks Automation (Germany) GmbH, 78256 Steißlingen (DE)
(72) Inventor: Schwetz, Michael, 8400 Winterthur (CH); Schmidt, Alexander, 8203 Schaffhausen (CH)
(74) Representative: Dehns Germany Partnerschaft mbB

(57) **Abstract**

The invention relates to a container (100) for storing and/or transporting a semiconductor fabrication article (190), particularly one or more of a wafer, a chip, a substrate and a photolithography mask, particularly an EUV reticle, the container (100) comprising an upper component (110) and a lower component (120), wherein the upper component (110) is reversibly attachable to the lower component (120), the container (100) further comprising an article support (140) provided within at least one of the upper (110) and the lower (120) components, wherein the article support (140) is configured to support one article (190) to be stored and/or transported in the container (100) and to restrict movement of the article (190) relative to the container (100), wherein the article support (140) is configured to elastically retract upon the article (190) being pushed towards the article support (140) by a pushing force (192), wherein the elastic retraction produces a counter force biasing the article (190) in a direction opposite the direction of the pushing force (192). The invention further provides a dual pod for storing and/or transporting a semiconductor fabrication article (190) using such a container (100) as an inner pod and an article support (140) for such a container (100).

## Description

The invention relates to devices for storing and/or transporting semiconductor fabrication articles.

### Background

Photolithography processes are widely used as one of the key steps in the manufacture of integrated circuits (ICs) and other semiconductor-related devices and/or structures. However, as the dimensions of features produced by such processes decrease, the importance of photolithography for the production of miniature ICs or other devices and/or structures rises.

In photolithography, a geometric pattern is transferred from a photomask (typically referred to as reticle) onto a substrate, for example a semiconductor wafer, by the use of light, a photosensitive layer and a subsequent etching step. Depending on the desired feature size on the substrate, the feature size of the reticle needs to be adapted as well as the wavelength of the light used for pattern transfer, with consideration of the Raleigh criterion.

In order to reduce the smallest achievable feature size, it has been proposed to use extreme ultraviolet (EUV) radiation. EUV radiation is electromagnetic radiation having a wavelength within the range of 5-20 nm, for example within the range of 5-10 nm.

Any contamination of the reticle may reduce the imaging performance of the photolithographic process and may in more serious cases require the reticle to be replaced. The reticle is typically expensive and therefore any reduction in the frequency with which it must be replaced is advantageous. Furthermore, replacement of the reticle is a time-consuming process, during which the photolithographic process may have to be suspended, thereby reducing its efficiency, which is undesirable.

For EUV applications, particle contamination with particle sizes of less than 10 nm as well as chemical contamination, for example by adsorption of volatile organic compounds, can be relevant.

The reticles used for such EUV applications are therefore typically stored in a storage stocker and retrieved when needed in connection with the lithography exposure equipment. Usually, the reticles are contained in a double shell container (dual pod) comprising a so-called EUV outer pod (EOP) and an EUV inner pod (EIP).

Such a dual pod is described in further detail in US 2019/0214287 A1, for example.

Since the acceptable level of particle contamination is extremely small, friction (which leads to abrasion and thus particle generation) of the reticle against the container as well as friction of container components relative to one another needs to be avoided. Therefore, typical EIPs are designed so as to accommodate one reticle in such a way that it has only very limited possibilities to move therein, for example by providing a respective accommodating cavity that essentially corresponds to the dimensions of the reticle to be stored therein. Typical EIPs are also equipped with additional reticle immobilizers to immobilize the reticle inside the EIP. In order to prevent contamination, the EIP is designed to enable a protective gas or vacuum to be applied to the reticle. To that end, typically orifices equipped with filter material are provided for the protective gas to enter from the EOP into the surroundings of the reticle contained in the respective EIP.

The EOP is equipped with actuators adapted to bias the reticle immobilizers of the EIP into a retaining position, thereby immobilizing the reticle inside the EIP when the EOP is attached to the EIP. The EOP also functions to immobilize the typically two pieces of the EIP against one another to prevent friction induced abrasion.

It is to be understood that the EIP components are moveable against one another as long as they are not immobilized from outside. In order to avoid friction induced abrasion caused by such movement, the EOP conventionally provides such immobilization functionality for the EIP while also providing protection against the surrounding atmosphere, which is necessary e.g. during transport between a storing position and process tools requiring reticles for operation.

EOPs are rather bulky, leading to high space requirements or "footprint" for stockers storing EUV reticles. Furthermore, they are made of polymeric material, which is also prone to abrasion and outgassing of volatile organic compounds. Therefore, WO 2021/104681 A1 proposes a clamping device for providing the immobilization functionality during storage with a significantly reduced spatial footprint.

Regardless of the specific means providing the immobilization functionality, this will always exert a force on the reticle stored within the EIP (or a dedicated storage pod). However, for example depending on specific requirements (and also on the specifications of different manufacturers) reticles are provided with different thicknesses, such that the force applied to these reticles by means of the same actuators of an EIP may vary. Similarly, depending on manufacturing accuracy with regard to dimensional trueness, the force applied to the stored reticle may vary from one pod to another or even from one immobilizer to another one within a single pod. It is, however, desirable to ensure a uniform application of the immobilization force across a stored reticle and to control the magnitude of the applied force.

### Summary

The present invention attempts to solve these problems by providing devices comprising features according to the independent claims. Advantageous embodiments and additional features are provided in the dependent claims and discussed in the following description.

The present invention provides reliable support and immobilization of reticles while ensuring an acceptable maximum force and uniform application of immobilization forces.

Aspects which can advantageously be considered when developing such an improved storage concept include that it is highly undesirable to change the way the reticles are provided to the photolithographic process equipment, this typically being the most complicated and costly part of a semiconductor production facility.

Therefore, since the photolithographic process equipment is typically adapted to receive dual pods, embodiments of the present invention are adapted to be used as components of such dual pods and/or as a replacement for traditional inner pods.

Additionally or alternatively, embodiments according to the present invention may be used (exclusively) during storage, while traditional dual pods may continue to be used for transporting reticles to and from photolithographic equipment.

In a first aspect, the invention provides a container for storing and/or transporting a semiconductor fabrication article, particularly one or more of a wafer, a chip, a substrate and a photolithography mask, particularly an EUV reticle. The container comprises an upper component and a lower component, wherein the upper component is reversibly attachable to the lower component. The container further comprises an article support provided in at least one of the upper and the lower components. The article support is configured to support one article to be stored and/or transported in the container and to restrict movement of the article relative to the container. Furthermore, the article support is configured to elastically retract upon the article being pushed towards the article support by a pushing force, wherein the elastic retraction produces a counter force biasing the article in a direction opposite the direction of the pushing force. This enables articles of varying dimensions, i.e. thickness, to be stored in identical containers without weakening the immobilization and without overly stressing the article.

It is to be noted that in the context of this specification, the term "container" is used for embodiments of this invention so as to avoid confusion with the term "pod" which is more commonly used in the art. Therefore, wherever in this specification, the term "container" is used to describe an embodiment of this invention, it can be replaced by the term "pod" without altering the meaning of the specification in any way.

In at least one embodiment, the container comprises at least one immobilizer configured to immobilize an article therein, when the upper component is attached to the lower component. Particularly, the immobilizer(s) is/are configured to push the article towards the article support. In at least one embodiment, the immobilizer(s) is/are provided in the upper component and the article support is provided in the lower component. Particularly, the immobilizer(s) may be configured to contact the article in a position substantially opposite a contact position between the article and the article support. In other words, the force applied to the article by the immobilizer(s) points directly towards the contact position between article and article support. This ensures a protection level which is comparable to the one provided by traditional dual pods, at least regarding mechanical damage to the stored or transported article.

In at least one embodiment, the at least one immobilizer is configured to be actuated by an outer pod of a dual pod as already described herein above. Alternatively or additionally, the at least one immobilizer can be provided in a static manner with respect to the component in which it is provided (for example, in the form of a static pushing pin or the like). In such a case, the force exerted on the article by the at least one immobilizer is determined by the counterforce provided by the article support against which the article is pushed by the respective immobilizer.

A further aspect of the invention provides a dual pod for transporting and/or storing an article, wherein the dual pod comprises a traditional outer pod and a container according to an embodiment of the invention as an inner pod.

The invention also provides an article support for a container according to the invention. The article support comprises at least one contact surface configured to support an article within a container in which the article support is mounted and an elastic member configured to enable the article support to elastically retract upon being pushed, particularly by a supported article.

In at least one embodiment, such an article support comprises at least one lateral guide member configured to restrict lateral movement of the article. This enhances mechanical safety of stored articles.

The elastic member may, for example, be provided in the form of a bending strip attachable to one of the upper and lower components with at least one end and/or an elastically compressible member configured to abut against one of the upper or lower components and spacing apart the respective component and the contact portion.

A further aspect of the invention provides a method of storing and/or transporting a semiconductor fabrication article comprising enclosing the article in a container as described herein, and storing the container within a storage position within a semiconductor fabrication stocker, particularly a reticle stocker.

In a further aspect, the invention provides a stocker for storing a semiconductor fabrication article, particularly one or more of a wafer, a chip, a substrate and a photolithography mask, particularly an EUV reticle, configured to perform a method as described herein and to hold a number of containers as described herein within storage positions in the stocker. The stocker, therefore, correspondingly enables the same advantages as the respective embodiments of the method and/or the container.

### Brief description of the drawings

Figure 1 schematically depicts an embodiment of a container according to the invention in a perspective view.
Figure 2 schematically depicts a lower component of the embodiment of Figure 1 during use in a top view.
Figures 3A to 7 schematically depict some embodiments of article supports according to the invention.

In the description of the drawings, like elements are referred to with identical reference numerals. Their respective description is not repeated for every figure for reasons of conciseness.

### Embodiment(s) of the invention

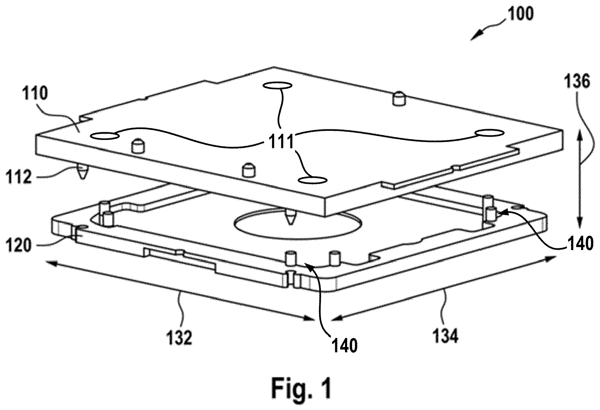

In Figure 1, an embodiment of a container according to the invention is schematically depicted in a perspective view and collectively referred to by reference numeral 100.

The container 100 comprises an upper component 110 and a lower component 120. During typical use of container 100, the geodesic references "upper" and "lower" have their common meaning, i.e. the upper component 110 is typically further away from the ground than the lower component 120.

The upper component 110 is attachable to the lower component 120, for example by relative movement towards the lower component 120 in a vertical direction 136. In the example shown here, the upper component 110 comprises guide pins 112 (in the example shown here, four such pins 112 are provided) for proper alignment of the upper 110 and lower 120 components relative to one another. To this end, the pins 112 extend into the lower component 120, when the two components 110, 120 are attached to one another. The pins 112 then restrict movement of the upper 110 and lower 120 components relative to one another in lateral (horizontal) directions 132, 134.

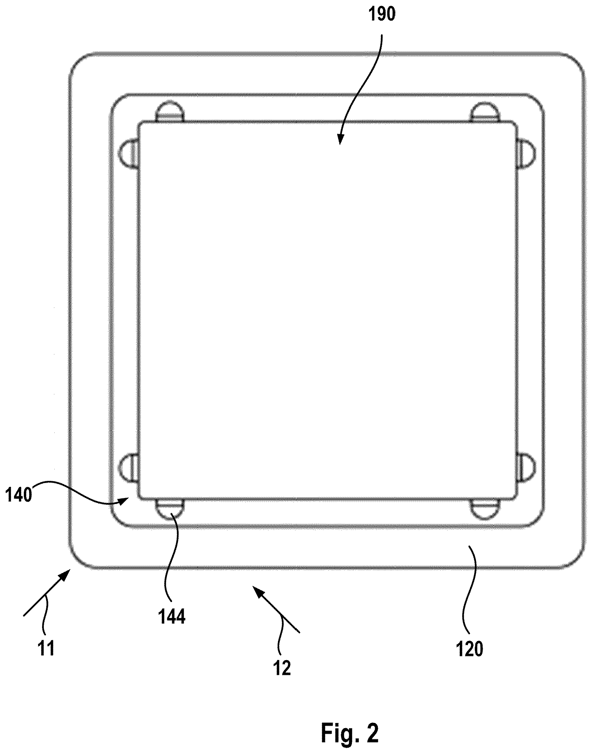

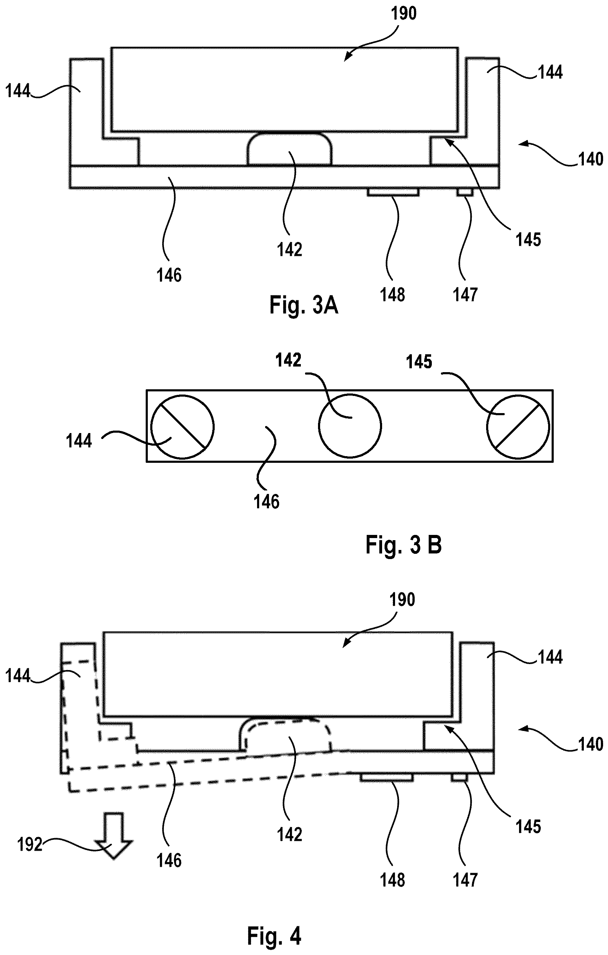

In the embodiment shown, the lower component 120 comprises article supports 140, which in this case are provided in every corner of lower component 120 in order to support an article to be stored and/or transported within the container 100. Figure 2 shows the lower component 120 of Figure 1 in a top view with an article 190, e.g. an EUV reticle, supported by the article supports 140. Furthermore, in Figure 2, viewing directions 11 ("diagonal viewing direction") and 12 ("tangential viewing direction") are illustrated. These viewing directions will be referred to in the context of Figs. 3 to 7, which all depict embodiments of article supports 140 according to the invention.

In Figure 3A and B, a first embodiment of an article support 140 is schematically depicted in a side view in the diagonal viewing direction 11 (Fig. 3A) and a top view (Fig. 3B). In Figure 4, the working principle of this embodiment is illustrated.

The article support 140 comprises a contact portion 142 with a contact surface on which the article 190 is supported during use of the article support 140. The contact portion 142 is provided on a bending strip 146 which is used as an elastic member in this embodiment and serves to allow the article support 140 to elastically retract when the article is pushed towards the article support 140 (in the direction indicated by arrow 192 in Fig. 4) as illustrated in Fig. 4. The bending strip 146 is attached to the lower component 120 of container 100 via a fastening 147 at one end of the bending strip 146, whereas the other end is free to move in the vertical direction. An alignment member 148 is provided to ensure proper positioning of the article support 140. This alignment member may engage with a respective counterpart provided in the lower component 120 or may simply abut against the lower component 120 in order to define a relaxed position of bending strip 146 (i.e. a position in which the bending strip 146 will rest without any pushing force 192 applied). The article support 140 further comprises lateral guide members 144 extending in a vertical direction from the bending strip and configured to restrict a lateral movement of the article 190 supported thereon, i.e. in the directions 132, 134.

When the article 190 is pushed towards the article support 140, e.g. by immobilizers 111 provided in the upper component 110 of container 100, the pushing force 192 is transmitted to the bending strip 146 via contact portion 142, resulting in the bending strip 146 retracting in the direction of the pushing force 192. A maximum retraction is defined by a stopper 145 provided with the lateral guide member 144, in this embodiment. When the article 190 abuts against this stopper 145, any further applied pushing force is conducted to the bulk of the lower component 120 via this stopper 145 and fastening 147 and/or alignment member 148, respectively, but does not result in further retraction of bending strip 146. In other words, a counter force directed in an opposite direction as compared to pushing force 192 significantly increases as soon as stopper 145 contacts the article 190, since then, the force is determined by the compression of the article support 140 rather than its tensile strength (which is the case during activation of the bending strip 146).

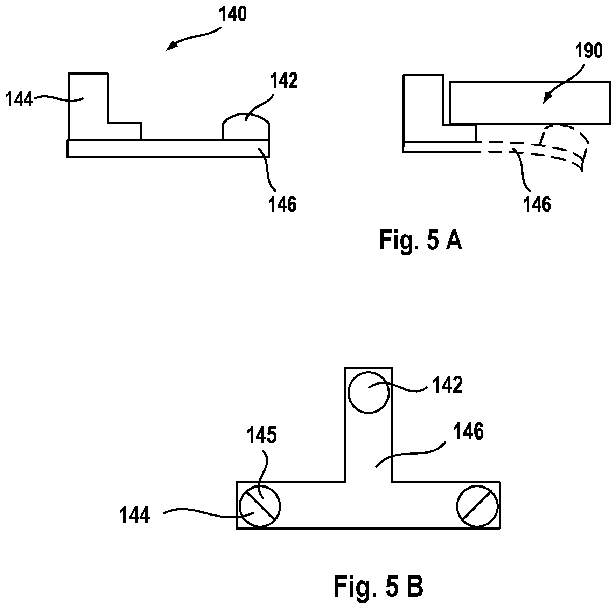

In Figs. 5A and 5B, a second embodiment of an article support 140 is depicted in side views (Fig. 5A) in the tangential viewing direction and in a top view (Fig. 5B). The second embodiment shown here differs from the first embodiment of Figs. 3 and 4 particularly in the positioning and attachment of bending strip 146, which in this case points in the diagonal direction with respect to the container 100 as opposed to the tangential direction, with which the bending strip 146 of the first embodiment of Figs. 3 and 4 is aligned. This difference in alignment results in a different distribution of bending forces and enables a more symmetrical behaviour of the article support 140. Particularly, the bending forces may at least partially result in torsional deformation of the bending strip 146 (the portion connecting the two lateral guide members 144. In this case, both ends of bending strip 146 may be attached to the lower component 120 and only the projecting part carrying the contact portion 142 may be free to retract upon being pushed by the article 190. In this second embodiment, stoppers 145 on both lateral guide members 144 accommodate the article once the bending path is used to its maximum, thereby reducing local stress on the article in each point contacting the stopper 145.

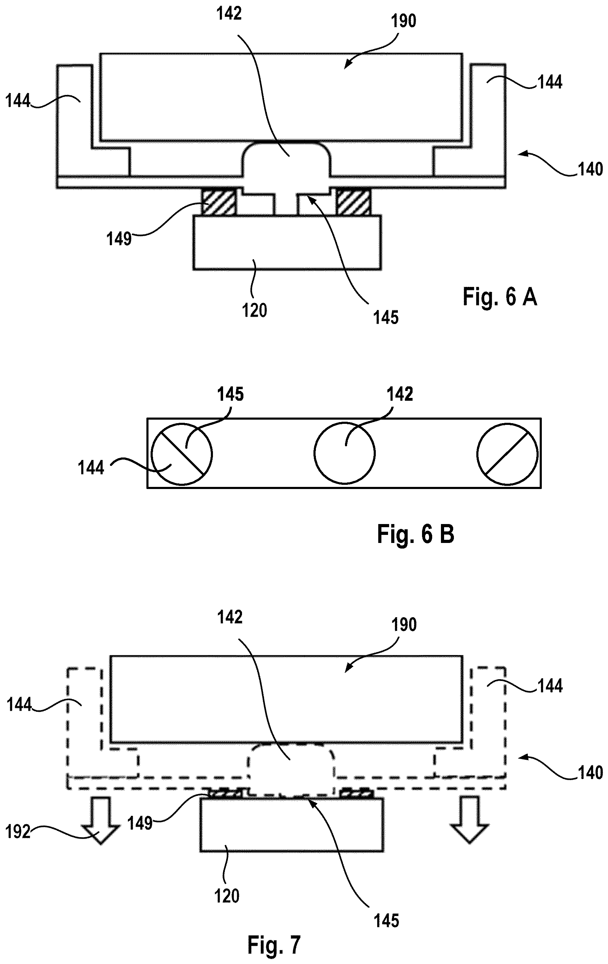

In Figures 6A, 6B and 7, a third embodiment of an article support 140 is depicted. This third embodiment differs from the first and second embodiments particularly in the realization of the elastic member, which in this case is provided in the form of an elastically compressible element 149, for example an O-ring. In this case, a maximum displacement (retraction) of the article support 140 may be defined by a stopper 145 which is provided directly underneath the contact portion and on a side opposite the contact surface, i.e. on the side on which the compressible element 149 is provided. In the example shown here, the stopper is provided in the form of a shoulder restricting the maximum compression of the compressible member. This stopper may particularly be dimensioned such that the maximally tolerable strain of the compressible element 149 used is not exceeded (i.e. a minimum of available space between the lower component 120 and the article support 140 or the contact portion 142, respectively, is ensured).

Regardless of the specific embodiment used, the article support 140 may comprise any suitable material for the application as described herein. Particularly suitable materials include plastics with low outgassing characteristics and high abrasion resistance, such as PEEK, FEP, POM, PC, FKM, HDPE, PAEK, PEI, PPS, PTFE, or similar polymeric materials as well as metals such as titanium, aluminium, magnesium or stainless steel as well as their alloys. In some embodiments, the article support comprises at least one ESD (electrostatic discharge) material. Electrostatic charge on the article can thereby discharge with a defined impedance of the article support. For example, such an ESD material can be a compound or composite comprising carbon, particularly electrically conductive carbon black and/or carbon fibres and/or carbon nanotubes and/or fullerenes and/or graphene.

## Claims

1. Container (100) for storing and/or transporting a semiconductor fabrication article (190), particularly one or more of a wafer, a chip, a substrate and a photolithography mask, particularly an EUV reticle,
the container (100) comprising an upper component (110) and a lower component (120),
wherein the upper component (110) is reversibly attachable to the lower component (120),
the container (100) further comprising an article support (140) provided with at least one of the upper (110) and the lower (120) components,
wherein the article support (140) is configured to support one article (190) to be stored and/or transported in the container (100) and to restrict movement of the article (190) relative to the container (100),
wherein the article support (140) is configured to elastically retract upon the article (190) being pushed towards the article support (140) by a pushing force (192),
wherein the elastic retraction produces a counter force biasing the article (190) in a direction opposite the direction of the pushing force (192).

2. Container (100) according to claim 1, comprising at least one immobilizer (111) configured to immobilize an article (190) therein, when the upper component (110) is attached to the lower component (120), wherein the at least one immobilizer (111) is configured to push the article (190) towards the article support (140).

3. Container (100) according to claim 2, wherein the at least one immobilizer (111) is provided in the upper component (110) and the article support (140) is provided in the lower component (120).

4. Container (100) according to claim 2 or 3, wherein the at least one immobilizer (111) is configured to contact the article (190) in a position substantially opposite a contact position between the article (190) and the article support (140).

5. Dual pod for transporting and/or storing a semiconductor fabrication article (190) comprising an outer pod and a container according to any one of the preceding claims as an inner pod.

6. Article support (140) for a container according to any one of claims 1 to 4, comprising a contact portion (142) provided with a contact surface for supporting an article (190), and an elastic member (146, 149) configured to enable the article support (140) to elastically retract upon being pushed (192), particularly by a supported article (190).

7. Article support (140) according to claim 6, wherein the elastic member (146, 149) comprises a bending strip (146) attachable (147) to one of the upper and lower components (110, 120) with at least one end and/or an elastically compressible member (149) configured to abut against one of the upper or lower components (110, 120) and spacing apart the respective component (110, 120) and the contact portion (142).

8. Article support (140) according to claim 6 or 7, comprising at least one lateral guide member (144) configured to restrict lateral movement of the article (190).

9. Method for storing and/or transporting a semiconductor fabrication article (190) comprising enclosing the article (190) in a container (100) according to any one of the preceding claims, and storing the container (100) within a storage position within a semiconductor fabrication stocker, particularly a reticle stocker.

10. Stocker for storing a semiconductor fabrication article (190), particularly one or more of a wafer, a chip, a substrate and a photolithography mask, particularly an EUV reticle, configured to perform a method according to claim 9 and to hold a number of containers (100) according to any one of claims 1 to 10 within storage positions in the stocker.
